Europäisches Patentamt

European Patent Office

Office européen des brevets

(11) Publication number: **0 097 147**
**B1**

(12) **EUROPEAN PATENT SPECIFICATION**

(45) Date of publication of patent specification: **03.09.86**

(21) Application number: **82900120.5**

(22) Date of filing: **21.12.81**

(86) International application number:
**PCT/GB81/00280**

(87) International publication number:
**WO 83/02362 07.07.83 Gazette 83/16**

(51) Int. Cl.⁴: **H 01 L 21/90**

(54) **IMPROVEMENT IN AND RELATING TO THE MANUFACTURE OF WAFER SCALE INTEGRATED CIRCUITS.**

(43) Date of publication of application:
**04.01.84 Bulletin 84/01**

(45) Publication of the grant of the patent:
**03.09.86 Bulletin 86/36**

(84) Designated Contracting States:
**BE CH DE FR LI NL SE**

(56) References cited:
**DE-A-2 015 841**
**US-A-4 257 826**

**Electronics, vol. 50, no. 16, August 1977, (New York, US), L. Curran: "Photorepeater works directly on wafers", pages 115-117**

(73) Proprietor: **BURROUGHS CORPORATION (a Michigan corporation)**
**Burroughs Place**
**Detroit, Michigan 48232 (US)**

(73) Proprietor: **BURROUGHS MACHINES LIMITED**
**Heathrow House, Bath Road Cranford**
**Hounslow Middlesex TW5 9QL (GB)**

(72) Inventor: **BAILLIE, Alan George**
**10 Lothian Crescent Causwayhead**
**Stirling Stirlingshire (GB)**

(74) Representative: **Kirby, Harold Douglas Benson et al**
**G.F. Redfern & Company Marlborough Lodge 14 Farncombe Road**
**Worthing West Sussex BN11 2BT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a method for providing metallisation patterns on a wafer scale integrated circuit.

A wafer-scale integrated circuit can be defined as a whole wafer of active circuits mounted in a single package. A large number of usually identical, separately functional integrated circuits are provided on a single, semi-conducting wafer. Certain electrical connections, known as Global connections, are common to all or most of the integrated circuits. Power connections, and connections carrying common control signals are suitable subjects for Global treatment. Any signal which is provided to a substantial proportion of the integrated circuits on the wafer is a Global signal.

The extensiveness of the distribution of the Global signals on a wafer-scale integrated circuit necessitates that the signal be distributed via metal conduction paths in order to minimise losses.

In the present state of the art there exist two methods for making the metallization pattern required by a wafer-scale integrated circuit.

In a first method one mask is used which is common to all of the individual integrated circuits on the wafer. The mask is used first on one location on the wafer, then in another, to mark out a repetitive plurality of metal areas on the wafer, each area corresponding to the metallization pattern of an individual integrated circuit. This process is known as "step and repeat", that is the same pattern being repeated at controlled intervals across the wafer. The metal areas for each of the integrated circuits can include Global lines, in which case the disposition and necessary repetitive symmetry of these connections place severe limitations on the manner in which the Global connections can be made. It is more usually the case that the metal areas for the individual integrated circuits are laid down as a first pattern of metallization, and interconnections between the individual integrated circuits are laid down as a second pattern of metallization. This necessitates a cost and time consuming two pass metallisation process.

In a second method a reticle can be used, that is, a mask which covers all or most of the area of the wafer. The metallization pattern both within each of the integrated circuits on the wafer and therebetween is laid down as a single process.

In this second method a first problem arises concerning the positional accuracy which can be defined by a reticle. While the step-and-repeat method currently allows for the definition of position on the wafer and consequent control of conductor dimensions to within around 2 micrometers, the use of a reticle, which can be generated only as accurately as the pattern generator which creates it, allows only that a position on the wafer be defined with an accuracy of the order of 10 micrometers. This five-to-one loss of definition in conductor positions and dimensions necessitates that the individual integrated circuits on the wafer be much more loosely packed with components than might otherwise be possible using a step-and-repeat metallization masking process. The loss of a real efficiency so encountered makes the use of a single reticle metallization masking process for a wafer scale integrated circuit most unattractive.

A second problem arises with this second method in that, while it is relatively easy to align a step-and-repeat small area mask over a wafer, it is extremely difficult and time consuming and requires much skill to so align a reticle which bears individual circuit detail.

In an article entitled "Photorepeater works directly on Wafers" in "Electronics International", Vol. 50 No. 16: Lawrence Curran describes a step-and-repeat photomasking process for the fabrication of integrated circuits wherein a serial succession of masks of different types are each positioned over areas to be fabricated as integrated circuits on a wafer in the various stages of doping, etching and so on. Each mask is used once over each integrated circuit location on the wafer. The present invention seeks to provide improvement thereover by using such a step-and-repeat mask for the laying down of a metallization layer upon individual integrated circuits in a wafer scale integrated circuit together with using a single, reticle mask covering the whole wafer for defining a metallization pattern between the individual integrated circuit elements in the wafer scale integrated circuit. The present invention further seeks to provide improvement over the matter disclosed in Curran's article by showing a method where a single layer of deposited metal together with a single layer of photoresist may be exposed first using the step-and-repeat mask and then using the reticle mask to provide both on-circuit metallization and inter-circuit metallization in just one coating and etching process.

A wafer-scale integrated circuit is hereinafter defined as an integrated circuit comprising a plurality of identical integrated circuit areas on a common substrate, each of said areas being provided with a local pattern of electrically conductive metallization and said areas being interconnected for simultaneous operation by a Global pattern of electrically conductive metallization.

A step-and-repeat masking process is hereinafter defined as a masking process which uses the same mask in a plurality of locations on a substrate.

A reticle masking process is hereinafter defined as a masking process using a mask which covers the entire surface of a substrate.

The present invention consists in a method for metallizing an integrated circuit comprising a plurality of identical circuit areas on a common substrate employing a step-and-repeat mask to define features on each of said plurality of identical circuit areas, said method being characterised by comprising the steps of: coating said integrated circuit with a metal layer; coating said metal layer with a layer of photoresist; using said step-and-repeat mask over each of said plurality of identical circuit areas in turn to expose said layer of photoresist to radiation to define areas of said layer of photoresist in each of said plurality of identical circuit areas whereunder it is desired to leave a local metallization pattern; using a reticle mask covering the entire surface of said integrated circuit to expose said layer of photoresist to said radiation to define in said layer of photoresist areas whereunder it is desired to leave a pattern of Global metallization to provide electrical connection between said plurality of identical circuit areas; curing said photoresist layer in said areas whereunder it is desired to leave a portion of said metal layer; removing that portion of said layer of photoresist which is uncured; and etching said metal layer in those areas thereof wherefrom said uncured photoresist has been removed.

In a preferred embodiment a preferably silicon whole-wafer integrated circuit has been fabricated to the point of completion of diffusion and has coated thereover a layer of metal which makes ohmic contact, where required, with each one out of a plurality of areas of diffusion thereon. The metal is preferably coated with a layer of photoresist which preferably becomes etch-resistant subsequently to being exposed to light. The areas of diffusion are preferably all identical to one another, in which case the photoresist over the areas of diffusion is exposed to light using the same metallization defining mask for each of the areas on a step-and-repeat basis. The photoresist intermediate between the diffused areas is preferably exposed to light using a single reticle mask covering the whole area of the wafer and defining metallization intermediately between the areas. Subsequently to both exposures the photoresist is preferably cured and the unexposed part thereof preferably washed away. Thereafter the metal which is not protected by cured photoresist is preferably etched away to leave a pattern of metallisation on the wafer.

The invention, is further explained, by way of an example, by the following description in conjunction with the appended drawings, in which:

Figure 1 shows a diffused wafer substrate prior to metallization.

Figure 2 shows the substrate of figure 1 coated in metal;

Figure 3 shows the metal coated substrate of figure 2 further coated in unexposed photoresist;

Figure 4 shows the exposing of the photoresist for local metallization using a step-and-repeat mask;

Figure 5 shows the exposing of the photoresist for Global metallization using a reticle masking process.

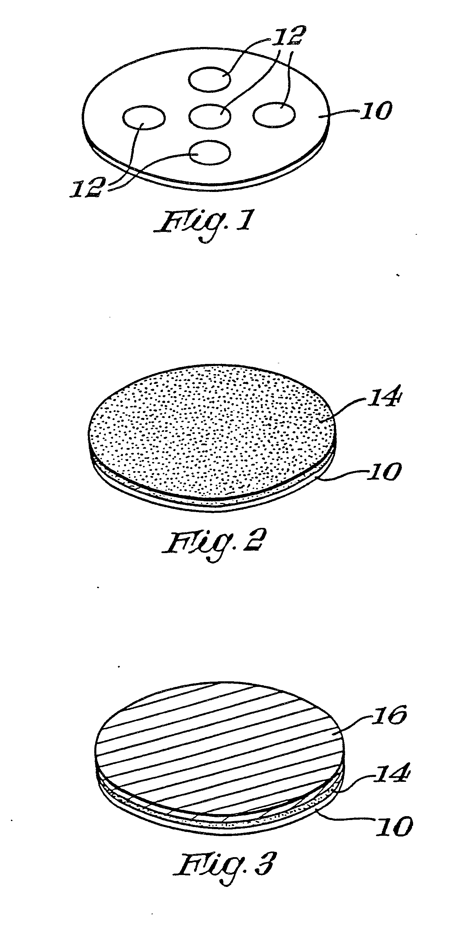

Figure 1 shows a silicon wafer 10 whereon have been diffused a plurality of identical areas 12 which require only the addition of the metallization to become functionable integrated circuits such as data processing cells. The areas 12 are further to be connected to one another and to the outside world to form a wafer scale integrated circuit whereon each of the areas 12 is simultaneously operable, dependently upon being capable of passing a functional test, as part of a larger circuit.

Figure 2 shows the wafer of figure 1 coated in a metallic layer 14. This is done in the normal way well known in the art of integrated circuit fabrication. The metal is aluminium, but could equally well be any other which is so usable. The metal layer 14 makes ohmic contact with those parts of the diffused areas 12 which are to be electrically connected to any other point by metallization.

Figure 3 shows the metal coated 14 wafer 10 of figure 2 further coated in a photoresist layer 16. The photoresist is of a type which can be cured only when light has been incident thereon.

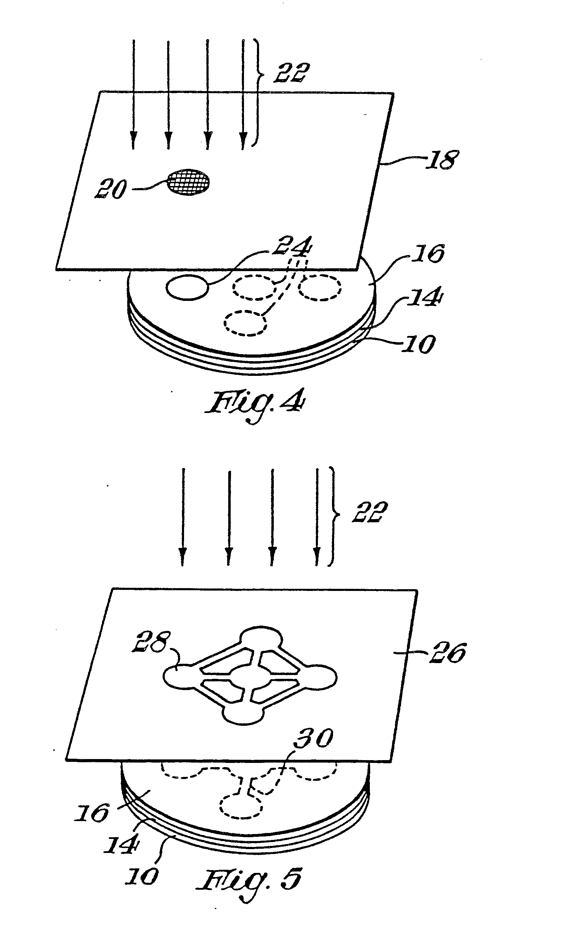

Figure 4 shows the exposure of the local metallization of the wafer scale integrated circuit.

A step and repeat mask 18 whereon there is only one area of transparency 20 bearing the pattern for the local metallization of the areas 12, is moved across the surface of the photoresist 16 on the metal 14 and wafer 10 and stopped in conjunction with the operation of a lightsource 22 to provide, over each of the diffused areas 12, an area of exposed photoresist 24 corresponding to the metallization pattern which is required on the areas 12.

Figure 5 shows the exposure of the photoresist 16, subsequently to the step-and-repeat exposure for the local metallization, to the light pattern required for the Global metallization.

A reticle mask 26 covers the entire area of the wafer 10. After the reticle mask 26 has been positioned, the light source 22 is operated to expose areas of Global lines 30 on the photoresist 16 in response to the Global metallization defining areas of transparency 28 on the reticle mask 26.

The photoresist 16 having thus been twice exposed, once for the local metallization and once for the Global metallization using a step-and-repeat optical mask and a reticle optical mask respectively, is cured so that those areas which have had light incident thereon become a tough polymer resistent to metal etching solution.

The metal layer 14 is etched leaving behind only those areas which are protected by the photoresist 16, i.e. leaving a pattern of metallization on the now wafer scale integrated circuit on the substrate 10 which has been defined according to the present invention.

It is to be appreciated that the diffused areas 12 need not all be identical to one another, several different kinds of areas being possible provided that the local metallization mask 18 is replaced by one mask for each of the different types of areas 12. It is further to be appreciated that other types of photoresistance schemes may be used, for example a photoresist which is cured only when it has not been exposed to the light being usable with masks 26, 18 which are modified to exclude light from those areas of metal 14 which are required to remain after etching. The order of step-and-repeat masking followed by reticle masking can be reversed, and indeed, the reticle masking can be performed amid the step-and-repeat masking steps. The reticle masking process for the Global lines can be performed in several stages.

## Claims

1. A method for metallizing an integrated circuit (10, 12) comprising a plurality of identical circuit areas (12) on a common substrate (10) employing a step-and-repeat mask (18, 20) to define features on each of said plurality of identical circuit areas (12), said method being characterized by comprising the steps of: coating said integrated circuit (10, 12) with a metal layer (14); coating said metal layer (14) with a layer of photoresist (16); using said step-and-repeat mask (18, 20) over each of said plurality of identical circuit areas (12) in turn to expose said layer of photoresist (16) to radiation (22) to define areas of said layer of photoresist (16) in each of said plurality of identical circuit areas (12) whereunder it is desired to leave a local metallization pattern (24); using a reticle mask (26, 28) covering the entire surface of said integrated circuit (10, 12) to expose said layer of photoresist (16) to said radiation (22) to define in said layer of photoresist (16) areas whereunder it is desired to leave a pattern of Global metallization (30) to provide electrical connection between said plurality of identical circuit areas (12); curing said photoresist layer (16) in said areas whereunder it is desired to leave a portion of said metal layer (14); removing that portion of said layer of photoresist (16) which is uncured; and etching said metal layer (14) in those areas thereof wherefrom said uncured photoresist (16) has been removed.

2. A method according to claim 1 wherein said use of said step-and-repeat mask (18, 20) and said use of said reticle mask (26, 28) include the use as said layer of photoresist (16) of a photoresist (16) which is cured to resist etching of said metal layer (14) only subsequently to incidence of said radiation (22) onto said layer (16) of photoresist (16).

3. A method according to claim 1 wherein said use of said step-and-repeat mask (18, 20) and said use of said reticle mask (26, 28) include the use as said layer of photoresist (16) of a photoresist (16) which is cured to resist etching of said metal layer (14) only in those areas of said layer of photoresist (16) which have not had said radiation (22) incident thereon.

4. A method according to any of the preceding claims wherein said radiation (22) is light radiation.

5. A method according to any of the preceding claims wherein said common substrate (10) is a circular semiconductor wafer (10) and wherein said plurality of identical circuit areas (12) is a plurality of data processing cells.

## Patentansprüche

1. Verfahren zum Metallisieren einer integrierten Schaltung (10, 12) mit mehreren identischen Schaltungsbereichen (12) auf einem gemeinsamen Substrat (10) unter Verwendung einer Weiterschaltungs- und -Wiederholungs-Maske (18, 20) zum Festlegen von Merkmalen auf jedem der mehreren identischen Schaltungsbereiche (12), gekennzeichnet durch die Schritte: Beschichten der integrierten Schaltung (10, 12) mit einer Metallschicht (14); Beschichten der Metallschicht (14) mit einer Fotolackschicht (16); Verwenden der Weiterschaltungs- und -Wiederholungs-Maske (18, 20) über jeden der mehreren identischen Schaltungsbereiche (12), um die Fotolackschicht (16) der Reihe nach einer Strahlung (22) auszusetzen, um Bereiche der Fotolackschicht (16) in jedem der mehreren identischen Schaltungsbereiche (12) festzulegen, unter denen das Hinterlassen eines lokalen Metallisierungsmusters (24) erwünscht ist; Anweden einer die gesamte Oberfläche der integrierten Schaltung (10, 12) bedeckenden Strichplattenmaske (26, 28), um die Fotolackschicht (16) der Strahlung (22) auszusetzen und in der Fotolackschicht (16) Bereiche festzulegen, unter denen das Hinterlassen eines globalen Metallisierungsmusters (30) erwünscht ist, um eine elektrische Verbindung zwischen den mehreren identischen Schaltungsbereichen (12) vorzusehen; Aushärten der Fotolackschicht (16) in den Bereichen, unter denen das Hinterlassen eines Abschnittes der Metallschicht (14) erwünscht ist; Entfernen des Abschnitts der Fotolackschicht (16), der nicht ausgehärtet ist; und Ätzen der Metallschicht (14) in den Bereichen, von denen der unausgehärtete Fotolack (16) entfernt worden ist.

2. Verfahren nach Anspruch 1, dadurch gekennzeichnet, daß die Verwendung der Weiterschaltungs- und -Wiederholungs-Maske (18, 20) und die Verwendung der Strichplattenmaske (26, 28) die Verwendung der Fotolackschicht (16) eines Fotolacks (16) einschließt, der ausgehärtet ist, um dem Ätzen der Metallschicht (14) nur im Anschluß an das Einfallen der Strahlung (22) auf die Schicht (16) des Fotolacks (16) zu widerstehen.

3. Verfahren nach Anspruch 1, dadurch gekennzeichnet, daß die Anwendung der Weiterschaltungs- und -Wiederholungs-Maske (18, 20) und die Anwendung der Strichplattenmaske (26, 28) die Anwendung der Fotolackschicht (16) eines Fotolacks (16) einschließt, der ausgehärtet ist, um dem Ätzen der Metallschicht (14) nur in den Bereichen der Fotolackschicht (16) zu widerstehen, auf die nicht die Strahlung (22) gefallen ist.

4. Verfahren nach einem der vorstehenden Ansprüche, dadurch gekennzeichnet, daß die Strahlung (22) aus einer Lichtstrahlung besteht.

5. Verfahren nach einem der vorstehenden Ansprüche, dadurch gekennzeichnet, daß das gemeinsame Substrat (10) aus einem kreisförmigen Halbleiterplättchen (10) besteht und daß die mehreren identischen Schaltungsbereiche (12) mehrere Datenverarbeitungszellen sind.

## Revendications

1. Procédé de métallisation d'un circuit intégré (10, 12) comportant un ensemble de zones de circuit (12) identiques sur un support commun (10) en utilisant un masque pour les opérations répétitives (18, 20) définissant les caractéristiques sur chacune des nombreuses zones identiques de circuit (12), ce procédé étant caractérisé en ce qu'il comprend les étapes suivantes: application d'un revêtement sur le circuit intégré (10, 12) constitué par une couche métallique (14); application sur cette couche métallique (14) d'une couche de revêtement photorésistante (16); utilisation d'un masque pour étapes répétitives (18, 20) sur chacune des nombreuses zones identiques de circuit (12) pour exposer successivement la couche photorésistante (16) au rayonnement (22) et définir les zones de la couche photorésistante (16) de chacune des nombreuses zones identiques de circuit (12) sous lesquelles on souhaite avoir un schéma de méallisation locale (24); on utilise un masque à réticule (26, 28) couvrant toute la surface du circuit intégré (10, 12) pour exposer la couche photorésistante (16) au rayonnement (22) et définir dans cette couche photorésistante (16) des zones en-dessous de celle-ci, zones dans lesquelles on souhaite laisser un schéma de métallisation globale (30) pour réaliser la connexion électrique entre l'ensemble de zones de circuit identiques (12); on fait durcir la couche photorésistante (16) dans les zones en-dessous desquelles on souhaite laisser une partie de la couche métallique (14); on enlève la partie de la couche photorésistante (16) qui n'a pas durci; on attaque chmiquement la couche métallique (14) dans les zones dans lesquelles on a enlevé la couche photorésistante non durcie (16).

2. Procédé selon la revendication 1, caractérisé en ce que l'utilisation du masque pour les étapes répétitives (18, 20) et l'utilisation du masque à réticule (26, 28) constituent à utiliser la couche photorésistante (16) qui a durci pour résister à l'attaque de la couche métallique (14) seulement après exposition du rayonnement (22).

3. Procédé selon la revendication 1, caractérisé en ce que l'utilisation du masque pour étapes répétitives (18, 20) et l'utilisation du masque à réticule (26, 28) constituent à utiliser une couche photorésistante (16) qui a durci pour résister à l'attaque de la couche métallique (14) seulement dans les zones de cette couche photorésistante (16) qui n'ont pas reçu le rayonnement (22).

4. Procédé selon l'une quelconque des revendications précédentes, caractérisé en ce que le rayonnement (22) est un rayonnement lumineux.

5. Procédé selon l'une quelconque des revendications précédentes, caractérisé en ce que le support commun (10) est une plaquette semiconductrice (10), circulaire et l'ensemble des zones de circuit (12) identiques est un ensemble de cellules de traitement de données.

Fig. 1

Fig. 2

Fig. 3

1

Fig.4

Fig.5